Europäisches Patentamt

(19) European Patent Office

Office européen des brevets

(11) Publication number: **0 063 043**
A1

(12) **EUROPEAN PATENT APPLICATION**

(21) Application number: 82301883.3

(22) Date of filing: 08.04.82

(51) Int. Cl.³: **G 03 F 7/08**
G 03 F 7/26, G 03 C 1/71
C 08 C 19/10, C 08 L 15/00

(30) Priority: 10.04.81 US 251957

(43) Date of publication of application:
20.10.82 Bulletin 82/42

(84) Designated Contracting States:
BE DE FR GB IT

(71) Applicant: PHILIP A. HUNT CHEMICAL CORP.
Palisades Park
New Jersey(US)

(72) Inventor: Turner, Edwin J.
23 Country Road
Barrington Rhode Island 02806(US)

(72) Inventor: Toukhy, Medhat A.
7 Congress Road
Barrington Rhode Island 02806(US)

(74) Representative: Ritter, Stephen David et al,
Mathys & Squire 10 Fleet Street
London EC4Y 1AY(GB)

(54) Cyclized rubber film-forming negative photoresist composition.

(57) A cyclized rubber film-forming negative photoresist composition which is comprised of a cyclized rubber polymer and an aryl bis-azide sensitizing compound which decomposes upon exposure to image-modulated light of selected wavelengths to yield a structure capable of inducing cross-linking of the polymer in the exposed areas of the composition. The cyclized rubber polymer is characterised by a narrow polydispersivity which is greater than 1.865, an unsaturation range of between about 6.0 to about 8.2 millimoles/gram, and an appropriate range of weight average molecular weights. The film-forming photoresist composition has both a high window-opening index and a high photospeed.

CYCLIZED RUBBER FILM-FORMING NEGATIVE
PHOTORESIST COMPOSITION

1.      Field of the Invention

The invention relates to a film-forming negative photoresist
composition which is comprised of a cyclized rubber polymer and an
aryl bis-azide sensitizing compound which decomposes upon exposure to
image-modulated light of selected wavelengths to yield a structure
capable of inducing cross-linking of the polymer in the exposed area
of the composition.  Cross-linking is defined as the union of high
polymer molecules by a system involving primary chemical bonds.

2.      Description of the Prior Art

Negative photoresists are important in the fabrication of
various devices by photolithographic procedures.  There is a
commerical need for negative photoresists which have both a high
window-opening index and a high photospeed.

The use of a negative resist constituting a polymer component
blended with an ultra-violet sensitive component capable of inducing
cross-linking of the polymer is known in the art.  Examples of such
resists are disclosed in U.S. Letters Patent Nos. 2,852,379;
2,940,850; 3,669,662 and 3,669,669.

It heretofore has been disclosed that if the polymer component
of the negative photoresist has a narrow molecular weight distribution
(polydispersivity) this will affect various characteristics of the
photoresist.

An example of a negative photoresist composition which incorporates a fractionated cyclized polymer with a narrow molecular weight distribution, is disclosed in Japanese patent No. 136,630. The cyclized polymer of this Japanese patent is a conjugated diene with a polydispersivity of 1.0-1.8. The resist is not a product which is commercially feasible to manufacture because the methods disclosed to obtain the product are far too costly.

Although many of the prior art negative photoresists disclosed are usable, there is a continuing commercial need for a negative photoresist composition which will produce a semi-conductor device with a greater packing density. The negative photoresist also must have a high photospeed and a high window-opening index.

In use, a negative photoresist composition is coated from solutions thereof by conventional methods, i.e. dipping, spraying, etc. on a suitable support on which the photoresist composition is exposed to light, i.e. the portions of the unexposed photoresist coating not to be removed are exposed. The exposed portions of the photoresist become insolubilized in the appropriate developer due to cross-linking by the sensitizer, thus allowing the unexposed portions of the photoresist coating subsequently to be removed by appropriate solvents in the development of the photoresist mask. The exposed surface of a substrate then can be suitable treated, e.g. etched.

The present invention provides film-forming negative photoresist compositions which are not subject to the drawbacks of prior art negative photoresist compositions.

Particularly this invention provides film-forming negative photoresist compositions of the character described which have a high window-opening index and a high photospeed and which are commercially feasible to manufacture and which can be sold at a competitive price. The film-forming negative photoresist compositions of the invention are also capable of producing semiconductor devices having a greater packing density than heretofore in a given space.

According to one aspect of the present invention there is provided a film-forming negative photoresist composition comprising a cyclized rubber polymer and an aryl bis-azide sensitizing compound which decomposes upon exposure to image-modulate light of selected wavelengths to yield a structure capable of inducing cross-linking of the polymer in the exposed areas of the composition, the polymer having a polydispersivity of greater than 1.865 and an unsaturation range of between about 6.0 to about 8.2 millimoles-unsaturation/gram.

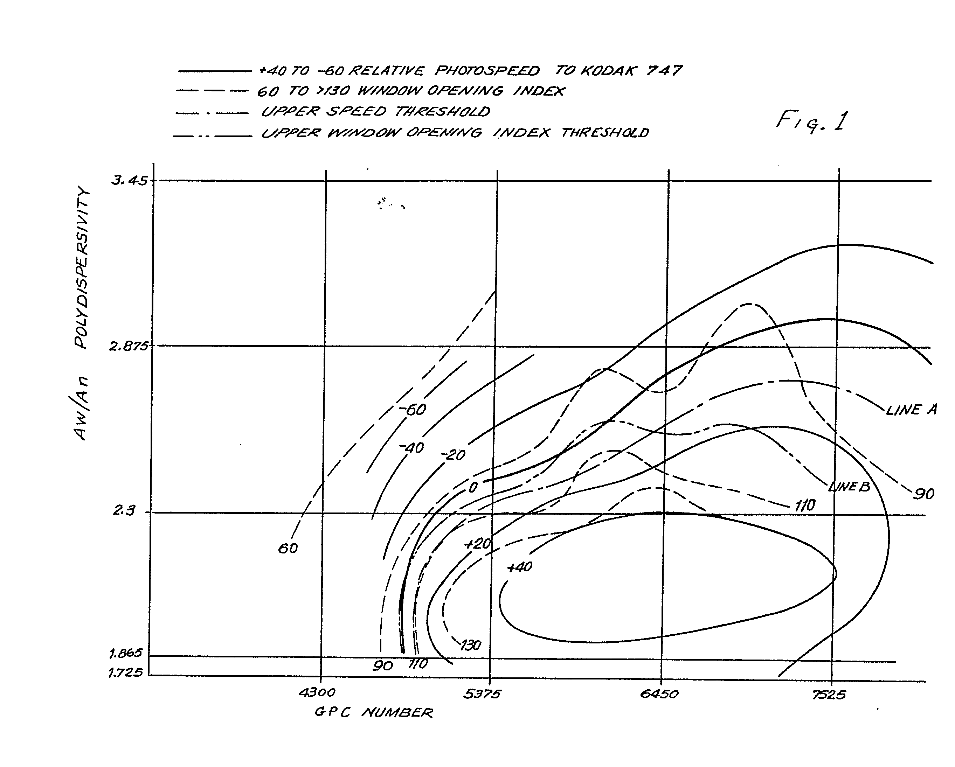

These photoresist compositions advantageously have a constitution such that they have photospeeds below line A of Fig. 1 and window opening indexes below line B of Fig. 1. Fig. 1 is a Cartesian graph with the polydispersivity of the cyclized rubber polymer on the ordinate axis and the weight average molecular weight of the cyclized rubber polymer on the abscissa axis; included on the graph are lines indicating the relative photospeed and lines indicating the window-opening indexes of various negative photoresists both as functions of polydispersivity, weight average molecular weight and unsaturation.

The term window-opening index as used herein and as indicated on Fig. 1 is the actual width of exposed and developed resist window produced using a 148.2 microinch mask line at sutiable exposure such that the fractional retained resist film thickness is 88 $\pm$ 3 percent after development. Window opening index as measured herein is thus relative to mask line dimensions. In other words, the greater the window opening index value the greater the capability of a resist to resolve and reproduce smaller mask geometries. The window opening indexes of various photoresists are indicated by the broken curved lines on Fig. 1. The window opening indexes of the negative resists of this invention, as heretofore stated, are such that they fall below line B of Fig. 1.

The invention also provides a method of preparing a cyclised rubber photoresist composition as defined above which comprises the steps of:

A.   dissolving a rubber polymer in an organic solvent to form a solution,

B.   incorporating a cyclization agent in the solution, and C.   cyclizing the rubber polymer until the residual unsaturation is in the range of about 6.0 to 8.2 millimoles unsaturation/gram.

The cyclization may be monitored to ascertain when the polymer has the required characteristics and will form a film-forming negative photoresist when mixed with an aryl bis-azide sensitizing composition.

Preferably the method of the invention involves the steps of:

A.   providing a starting cyclized rubber polymer having a weight average molecular weight of betwen about 3,000 to about 7,000, a polydispersivity of between about 2.3 to about 3.5 and an unsaturation value of between about 6.0 to about 8.2 millimoles unsaturation/gram;

B.   dissolving said starting cyclized rubber polymer in an organic liquid to form a solution; and

C.   adding to the cyclized rubber solution another organic liquid in which the starting cyclized rubber polymer is insoluble, for progressive solvent phase-separated fractionation of the cyclized rubber polymer, each progressive phase-separated fraction having progressively varying weight average molecular weights and progressively varying polydispersivitives, each progressive phase-separated fraction preferably having the same unsaturation value of between about 6.0 to about 8.2 millimoles unsaturation/gram.

The combined phase-separated fractions may be monitored to ascertain if a combined phase-separated fraction has the characteristics of the cyclised rubber polymer described above and to ascertain if the combined phase-separated fraction, when mixed with an aryl-bis-azide sensitizing compound of the type referred to above yields a film-forming negative photoresist of the desired window-opening index and photospeed.

As will become apparent hereinafter, one feature of this invention resides, briefly stated, in the provision of the film-forming negative photoresist composition which includes a cyclized rubber polymer component and an aryl bis-azide sensitizing compound that decomposes upon exposure to image-modulated light of selected wavelengths, e.g. ultra-violet, to yield a structure capable of acting as a cross-linking agent for the polymer. The resultant film-forming negative photoresist composition is characterized by a high window-opening index and a high photospeed.

The cyclized rubber polymer component of the instant film-forming negative photoresist composition may be characterised by three factors, each of which is present within a particular appropriate range.

The first factor is the "weight average molecular weight", herein referred to, for convenience, as "Aw" (Aw as used herein is not the true weight average molecular weight, but, rather, is a linear function of the true weight average molecular weight; the true weight average molecular weight is equal to the Gel Permeation Chromatograph (GPC) value times a Q factor of approximately 40.)

0063043

The second is unsaturation.

The third is molecular weight distribution which, for convenience, herein is referred to as "Aw/An" and herein is referred to as "polydispersivity" ("An" as used herein refers to the "number average molecular weight," but like Aw, An is not a true number average molecular weight; An is determined by multiplying the GPC value for number average molecular weight by a Q factor of approximately 40.)

The polydispersivity of the rubber polymer included in the photoresist composition of the present invention is narrow but must be greater than 1.865.

GPC values as used herein were determined by the use of a Waters Associates (of Milford, Mass.) Model ALC-GPC-201 liquid chromatograph using four microstyragel columns of sizes $10^3$ Angstroms, $10^5$ Angstroms and $10^6$ Anstroms, employing tetrahydrofuran at a flow rate of 2 milliliters per minute, the instrument being run at room temperature.

The detector used with the chromatograph was a Differential Reflectometer, Model 401, sold by Waters Associates.

The data handling was on a SIGMA 10 computer sold by Perkins-Elmer of Westport, Conn.

The GPC was standardized with polystyrene standards, sold by Pressure Chemical Co. of Pittsburgh, Pa.

The photoresist composition is used in a conventional manner as heretofore described.

According to the present invention a cyclized rubber polymer, with an appropriate polydispersivity, weight average molecular weight and unsaturation is blended with a sensitizing compound and suitable solvent. The sensitizing compound is an aryl bis-azide compound that decomposes upon exposure to image-modulated light of selected wavelengths, e.g. ultra-violet, to yield a structure capable of inducing cross-linking of the polymer in exposed areas of the negative film-forming resist composition. The cyclized rubber polymer together with the aryl bis-azide sensitizing compound and suitable solvent constitutes a film-forming negative photoresist composition.

Various different cyclized rubber polymers can be used in accordance with this invention. The cyclization polymer must have an appropriate weight average molecular weight, unsaturation and polydispersivity. The polydispersivity is always greater than 1.865.

The relative proportions of solid cyclized rubber polymer and solid sensitizing compound may be varied as desired or as conditions may require, but ordinarily the proportion of the solid sensitizing compound in the dried film-forming negative photoresist composition preferably are within the range of from about one to about five weight percent of the solid cyclized rubber polymer with the preferred range being from about two to about four weight percent.

The specific concentration of both the solid sensitizing compound and the solid polymer in the solvent can generally vary over a wide range, but will ordinarily be dependent upon the specific sensitizing compound used, upon the thickness of the photosensitive layers desired or required, and upon the specific application of the photo-insolubilized layer.

In use, the film-forming negative photoresist compositions of this invention are applied as a solution in a suitable solvent commonly employed in the art for coating polymers onto suitable supports conventionally used for photoresist elements.

In general, any inert solvent may be employed in view of its sole function as a mere volatile vehicle for coating the photosensitive composition onto a support element. The solids content - the cyclized rubber polymer and the sensitizing compound - of the negative photoresist composition, need only be sufficient to provide the desired essentially dry film thickness of the composition, which typically may be in the range of about 3,000 Angstroms to about 20,000 Angstroms thickness. Solid contents of from about seven to about thirty weight percent in resist solution provides the aforementioned thickness for the essentially dry film.

Photolytically induced cross-linking of the cyclized rubber polymer, can be effected by exposing the polymer/sensitizer composition to a source of image-modulated light of selected wavelengths. The light source need only furnish a sufficient amount of radiation to include the desired degree of insolubilization of the composition and preferably ultra-violet is used. Typically light having a wavelength of about 3,000 Angstroms is used. Preferred sources of light to furnish a sufficient amount of radiation are carbon arcs, mercury vapor lamps, etc.

The effect of the sensitizing compound, in the photoresist art, is to increase the solubility contrast between exposed and unexposed areas after development. It is necessary to choose the developing solvent with a certain degree of care; however, the choice of solvents is fairly wide.

The film-forming negative photoresist composition of this invention can be coated onto the substrate by any of the conventional methods used in the photoresist art which include dipping, spraying, spin-coating, etc. After application, the carrier solvent is driven off, as by evaporation, to leave a thin coating of the negative photoresist composition on the substrate, after which the coating may be exposed to suitable radiation in accordance with conventional techniques employed in the photomechanical and photolithographic arts.

The substrate has been coated with a film of the negative photoresist composition and dried. Desirably, the unexposed coating is prebaked at a low temperature, e.g. up to about 60 minutes. Convection, conduction, contact, or radiation heating (such as infrared or microwave) may be used. Then the coating is exposed as heretofore stated to light of selected wavelengths, e.g. ultra-violet, in a predetermined pattern corresponding to the ultimate pattern desired. Generally, such exposure is effected by means of suitable masks, negatives, stencils, templates, etc. Such exposure induces cross-linking of the coating in the exposed areas. The exposed coating may then be developed by treating it with any suitable solvent. Generally, because of the differential insolubility which has been induced, the solvent developer may be the same solvent in which the cyclized rubber polymer and the sensitizing compound were originally dissolved during the preparation of the negative film-forming photoresist. The unexposed areas are dissolved off, leaving a resist image corresponding to the exposed areas in which photo-insolublization was induced.

Additionally, a post-development heat treatment may be employed to increase the strength of the resist image. For the post-bake, the film and support may be oven baked below $300^{o}C$ for a suitable time.

A specific application for the film-forming photoresist composition of this invention is in the fabrication of semi-conductor devices. For example, the film-forming photoresist composition is coated on a silicon dioxide surface of a semiconductor substrate followed by exposure of the coating (after drying) in a predetermined pattern through a mask. The exposed coating then is developed to bare protected areas of the oxide layer for further processing which for example, then may be conventionally etched into appropriate openings for diffusion, metallization, or other operations as desired or required.

The film-forming negative photoresist compositions of this invention also are suitable for other uses. For example, they can be employed for the manufacture of printed circuits, chemical milling and in the various fields of photomechanical and photographical reproductions, lithography and intaglio printing, such as offset printing, silk screen printing, manifold stencil sheet coatings, lithographic plates, relief plates, gravure plates and the like.

Cyclized rubber polymers usable in the present invention may be obtained in a variety of ways, fractionation of the cyclized rubber polymer may be utilized but it is not essential. Hence, in accordance with this invention the cyclized rubber polymer may or may not be fractionated. The cyclized rubber polymer, used in the film-forming negative photoresist of this invention, when not fractionated, is prepared in the following manner 10g of either dried cis-1,4-polyisoprene, dried 1,4-polybutadiene, dried natural rubber (Hevea or Balata), or dried trans-1,4-polyisoprene are dissolved, usually in an inert atmosphere, in 200g of either anhydrous benzene, anhydrous toluene, anhydrous ethyl benzene, or anhydrous meta/para xylene mixture. To the above solution 0.5g of acidic catalytic cyclizing agent such as paratoluene sulfonic acid monohydrate, sulfuric acid, tin tetrachloride, titanium tetrachloride, fluoroboric acid, or trichloroacetic acid are added slowly with vigorous stirring. The reaction mixture is heated, the temperature to which it is heated is dependent upon the cyclizing agent used and is limited by the boiling point of the solvent. The cyclization is monitored by removing small samples for measurement of residual unsaturation and molecular weight properties as measured by Gel Permeation Chromotography. When the desired reaction product is obtained, (said desired reaction product having an unsaturation range of between about 6.0 to about 8.2 millimoles unsaturation/gram and molecular weight characteristics as defined in FIG. 1, and such desired reaction product further being such that when used to form a film-forming negative photoresist in the manner hereinafter described, forms a resist with a window-opening index below line B of FIG. 1, and a photospeed below line A of FIG. 1 which the desired reaction product (polymer component of the negative photoresist) has both a polydispersivity and weight average molecular weight readable on FIG. 1 for resists having the just defined parameters), the reaction mixture is cooled to room temperature. To ascertain when a desired reaction product, as heretofore defined, is obtained it is generally necessary to prepare a film-forming negative photoresist using a sample of said reaction product and to then test the resultant film-forming negative photoresist for its performance. After a few such samples of reaction product are so tested, it will become apparent to a person skilled in the art which reaction products, where tested as a component of the film-forming resist, yield the desired resist and hence are desired reaction products. At this point it should no longer be necessary to continuously test each reaction product by utilizing it in a sample film-forming negative photoresist, because procedures which have previously yielded the desired reaction products may simply be repeated and/or because other readily discernable characteristics of the desired reaction product will become apparent.

When the desired degree of cyclization (unsaturation) is obtained (said desired degree of unsaturation, as heretofore stated, being about 6.0 to about 8.2 millimoles-unsaturation/gram), the reaction mixture is cooled to room temperature and 10g of a quenching agent such as ammonium hydroxide 28%, calcium carbonate 33% aqueous slurry or sodium carbonate saturated solution are added in an amount sufficient to react with all of the acid. The acid catalyst reaction products are removed by filtration or other common laboratory techniques. In some cases this solution can be used directly to formulate the photoresist.

After filtration, an excess of either methanol, ethanol, isopropanol, or n-propanol is added to the cyclized rubber solution to precipitate the rubber. An excess of methanol, ethanol, isopropanol, or n-propanol is defined herein to mean an amount sufficient to precipitate all of the cyclized rubber. The rubber is then filtered and washed well with either methanol, ethanol, isopropanol, or n-propanol and dried to remove the solvent. The drying may be done by air drying, vacuum drying, or with heat below 50°C in an inert atmosphere.

When it is desired to have the cyclized rubber polymer used in the film-forming negative resist frationated, said fractionated cyclized rubber polymer is prepared as follows: a cyclized rubber polymer, said cyclized rubber polymer being one which has the following characteristics:

weight average molecular weight (Aw) = about 3,000 to
    about 7,000
polydispersivity = about 2.3 to about 3.5
unsaturation value = about 6.0 to about 8.2 millimoles-
    unsaturation/gram,

is dissolved in either benzene, toluene, ethyl benzene, or mixed xylene to form either a 10%, 6%, 3%, or 1% solution. With vigorous stirring a non-solvent which is either methanol, ethanol, isopropanol, or n-propanol is added slowly until a combined phase-separated fractionated cyclized rubber phase is obtained having the overall desired polydispersivity and weight average molecular weight as measured GPC. The phase-separated fractionated rubber phases will have varying weight average molecular weight ranges and varying polydispersivity ranges but the unsaturation value range will remain essentially the same as in the starting cyclized rubber. In other words, rubber may be progressively fractionated from the solution as additional non-solvent is added thereto. Phase-separated fractions of rubber may be combined with one another and it is this combination of phase-separated fraction which is tested for desired polydispersivity and desired weight average molecular weight. To see if the combined phase-separated rubber fraction phase is usable in the film-forming negative resists of this invention, said combined phase-separated rubber phase is tested for the same characteristics and in the same manner as was heretofore described for testing to ascertain if the cyclized rubber reaction product is a desired reaction product. Once it is ascertained that the phase-separated fractionated rubber phase is usable in the resist, the phase-separated fractionated rubber is separated and the non-solvent is removed under vacuum.

All of the foregoing examples result in a cyclized rubber polymer with a narrow polydispersivity which is usable to form a high quality negative photoresist. The polydispersivity of the polymer is always greater than 1.865.

The film-forming negative photoresist of the present invention may be prepared in the following manner: to 100g of 11% cyclized rubber solution (in mixed xylenes), about 0.44g of any of the following sensitizers is added: 4,4'-Bisazidostilbene; 4,4'-Bis-azidobenzophenone; 4,4'-Bisazobenzalacetone; 2,6-Bis (4'-azido-benzylidiene)-4-methylcyclohexanone; 4,4'-Bisazidochalcone; 1,2-Bis (4-azidocinnamoyloxy)-ethane. The preferred sensitizing compound is 2,6-Bis(4'-azidobenzylidiene)-4-methylcyclohexanone.

The above mixture is stirred until solution is complete. After filtration to remove any particulate matter, the solution is coated preferably using spin-coating techniques.

The resultant film-forming negative photoresists were tested for their performance, specifically both the photospeed and window-opening index of the film-forming resists were measured. The cyclized rubber polymers used in the resists were analyzed for both weight average molecular weight, polydispersivity and unsaturation. The polydispersivity and weight average molecular weight of the cyclized rubber polymers utilized can best be seen from FIG. 1, which is Cartesian graph in which the polydispersivities of the polymer components usable in this invention are readable on the ordinate axis and in which the weight average molecular weights of the polymer components usable in this invention are readable on the abscissa axis. On the graph of FIG. 1 are lines indicating the relative photospeeds of various negative photoresists whose characteristics are plotted on the graph, the relative photospeeds being a function of the polydispersivity; the weight average molecular weight and the unsaturation of the polymer. Also on the graph of FIG. 1 are lines indicating the window-opening indexes of various negative photoresists whose characteristics likewise are plotted on the graph, the window-opening indexes also being a function of polydispersivity, weight average molecular weight and unsaturation of the polymer. From the graph of FIG. 1, it is possible to ascertain both the weight average molecular weight and the polydispersivity of polymer components which are usable to obtain a resultant negative photoresist which has a certain measured photospeed and a cerain measured window-opening index.

Thus negative photoresists of this invention have relative photospeeds falling below line A of FIG. 1, and all are characterized by containing a polymer component with a narrow polydispersivity, said polydispersivity always being greater than 1.865.

The relative photospeeds of various negative photoresists are indicated by the solid curved lines on FIG. 1, those of the invention, as heretofore stated, falling below line A of FIG. 1. The photospeeds illustrated on FIG. 1 were obtained using a Perkin Elmer Micralign, Model 111 (1.0 mm slit width, aperture No. 3) and were calculated according to the following formula wherein:

$P$ = relative photospeed of sample;

$T_k$ = traverse time of reference;

$T_s$ = traverse time of sample; and

$$P = \frac{(T_k - T_s)100}{T_k}$$

The relative photospeeds were tested such that there was equal film thickness losses after development for all samples tested. Eastman Kodak 747 negative resist was used for the photospeed comparison. Eastman Kodak 747 had a traverse time of 7.65 seconds. Traverse time is proportional to exposure time and is the actual time it takes to scan-expose the wafer.

The window-opening idexes of various photoresists are indicated by the broken curved lines on FIG. 1. The window-opening indexes of the negative resists of this invention, as heretofore stated, are such that they fall below line B of FIG. 1. The term window-opening index as used herein and as indicated on FIG. 1 is the actual width of the developed window after suitable exposure through a mask opening of a given predetermined width which for the use of the foregoing term herein and for FIG. 1 is 148.1 microinches. In other words, window-opening indexes are expressed in terms of developed image widths and are proportional to the capability of the resist to develop open smaller geometries. The numbers on FIG. 1, indicating window-opening indexes are actual measurements in microinches of developed image widths measured at a given predetermined retained film thickness after development. All samples were tested such that the fractional retained film thickness after development was $88 \pm 3\%$. Window-opening index as measured herein is thus relative to mask dimensions.

The following Examples illustrate the production of negative photoresist compositions according to the invention. In these Examples "sensitizer D" is 2,6-Bis(4'-azidobenzylidene)-4-methylcyclohexane.

## Example 1

### Preparation of Cyclized Rubber

In an inert atmosphere dried natural rubber (heavea or balta) (10 g.) was dissolved in 200 g. of dried ethyl benzene. To this solution 0.5 g. of tin tetrachloride was added slowly with vigorous stirring. The reaction mixture was heated and the cyclization was monitored by removing small samples for measurement of residual unsaturation. When the desired degree of cyclization (unsaturation) was attained, the reaction mixture was cooled to room temperature and 10 g. of sodium carbonate saturated solution were added. After filtration, the cyclized rubber solution was added to an excess of isopropanol to precipitate the rubber. The rubber was filtered and washed well with isopropanol.

### Fractionation of Cyclized Rubber

The cyclized rubber is dissolved in ethyl benzene to form a solution. With vigorous stirring the non-solvent isopropanol is added slowly until the precipitated rubber phase has the desired polydispersity and Aw as measured by GPC. At that point the precipitated rubber is separated and the non-solvent is removed by vacuum distillation.

### Preparation of Photoresists

To 100 g. of an 11 percent cyclized rubber solution (in mixed xylenes) was added 0.44 g. of sensitizer D. The mixture was stirred until solution was complete. After filtration to remove any particulate matter, this solution was coated using spin-coating techniques.

## Example 2

### Preparation of Cyclized Rubber

In an inert atmosphere dried 1,4-polybutadiene (10. G) was dissolved in 200 g. of dried toluene. To this solution 0.5 g. of trichloro acetic acid was added slowly with vigorous stirring. The reaction mixture was heated and the cyclization was monitored by removing small samples for measurement of residual unsaturation. When the desired degree of cyclization (unsaturation) was attained, the reaction mixture was cooled to room temperature and 10 g. of ammonium hydroxide (28 percent) were added. After filtration, the cyclized rubber solution was added to an excess of isopropanol to precipitate the rubber. The rubber filtered, and washed well with methanol.

### Fractionation of Cyclized Rubber

The cyclized rubber is dissolved in toluene to form a 6 percent solution. With vigorous stirring the non-solvent methanol is added slowly until the precipitated rubber phase has the desired polydispersity and $\bar{A}w$ as measured by GPC. At that point the precipitated rubber is separated and the non-solvent is removed by vacuum distillation.

### Preparation of photoresists

To 100 g. of an 11 percent cyclized rubber solution (in mixed xylenes) was added 0.44 g. of sensitizer D. The mixture was stirred until solution was complete. After filtration to remove any particulate matter, this solution was coated using spin-coating techniques.

Example 3

Preparation of Cyclized Rubber

In an inert atmosphere dried cis-1,4-polyisoprene (10 g.) was dissolved in 200 g. of dried benzene. To this solution 0.5 g. of paratoluene sulfonic acid monohydrate was added slowly with vigorous stirring. The reaction mixture was heated and the cyclization was monitored by removing small samples for measurement of residual unsaturation. When the desired degree of cyclization (unsaturation) was attained, the reaction mixture was cooled to room temperature and 10 g. of ammonium hydroxide (28 percent) were added. After filtration, the cyclized rubber solution was added to an excess of methanol to precipitate the rubber. The rubber was filtered, and washed well with methanol.

Fractionation of Cyclized Rubber

The cyclized rubber is dissolved in benzene to form a 10 percent solution. With vigorous stirring the non-solvent methanol is added slowly until the precipitated rubber phase has the desired dispersity and Aw and measured by GPC. At that point the precipitated rubber is separated and the non-solvent is removed by vacuum distillation.

Preparation of Photoresists

To 100 g. of an 11 percent cyclized rubber solution (in mixed xylenes) was added 0.44 g. of sensitizer D. The mixture was stirred until solution was complete. After filtration to remove any particulate matter, this solution was coated using spin-coating techniques.

Example 4

Preparation of Cyclized Rubber

In an inert atmosphere dried trans 1,4-polyisoprene (10 g.) was dissolved in 200 g. of dried metal/para xylene mixture. To this solution 0.5 g. of titanium tetrachloride was added slowly with vigorous stirring. The reaction mixture was heated and the cyclization was monitored by removing small samples for measurement of residual unsaturation. When the desired degree of cyclization (unsaturation) was attained, the reaction mixture was cooled to room temperature and 10 g. of hydroxide (28 percent) were added. After filtration, the cyclized rubber solution was added to an excess of n-propanol to precipitate the rubber. The rubber was filtered, washed well with methanol.

Fractionation of Cyclized Rubber

The cyclized rubber is dissolved in mixed xylene to form a 1 percent solution. With vigorous stirring the non-solvent n-propanol is added slowly until the precipitated rubber phase has the desired polydispersity and Aw as measured by GPC. At that point the precipitated rubber is separated and the non-solvent is removed by vacuum distillation.

Preparation of Photoresists

To 100 g. of an 11 percent cyclized rubber solution (in mixed xylenes) was added 0.44 g. of sensitizer D. The mixture was stirred until solution was complete. After filtration to remove any particulate matter, this solution was coated using spin-coating techniques.

## Example 5

### Preparation of Cyclized Rubber

In an inert atmosphere dried 1,4-polybutadiene (10 g.) was dissolved in 200 g. of dried toluene. To this solution 0.5 g. of sulfuric acid was added slowly with vigorous stirring. The reaction mixture was heated and the cyclization was monitored by removing small samples for measurement of residual unsaturation. When the desired degree of cyclization (unsaturation) was attained, the reaction mixture was cooled to room temperature and 10 g. of calcium carbonate 33 percent aqueous slurry was added. After filtration, the cyclized rubber solution was added to an excess of ethanol to precipitate the rubber. The rubber was filtered, and washed well with ethanol.

### Fractionation of Cyclized Rubber

The cyclized rubber is dissolved in toluene to form a 6 percent solution. With vigorous stirring the non-solvent ethanol is added slowly until the precipitated rubber phase has the desired polydispersity and Aw and measured by GPC. At that point the precipitated rubber is separated and the non-solvent is removed by vacuum distillation.

### Preparation of Photoresists

To 100 g. of an 11 percent cyclized rubber solution (in mixed xylenes) was added 0.44 g. of sensitizer D. The mixture was stirred until solution was complete. After filtration to remove any particulate matter, this solution was coated using spin-coating techniques.

Example 6


Preparation of Cyclized Rubber


        In an inert atmosphere dried natural rubber (10 g.) was
dissolved in 200 g. of dried benzene.  To this solution 0.5 g. of
paratoluene sulfonic acid monohydrate was added slowly with vigorous
stirring.  The reaction mixture was heated and the cyclization was
monitored by removing small samples for mesurement of residual
unsaturation.  When the desired degree of cyclization (unsaturation)
was attained, the reaction mixture was cooled to room temperature and
10 g. of ammonium hydroxide (28 percent) was added.  After filtration,


the cyclized rubber solution was added to an excess of isopropanol to
precipitate the rubber.  The rubber was filtered.


Fractionation of Cyclized Rubber


        The cyclized rubber is dissolved in ethyl benzene to form a 10
percent solution.  With vigorous stirring the non-solvent methanol is
added slowly until the precipitated rubber phase has the desired
polydispersity and Aw as measured by GPC.  At that point the
precipitated rubber is separated and the non-solvent is removed by
vacuum distillation.


Preparation of Photoresists


        To 100 g. of an 11 percent cyclized rubber solution (in mixed
xylenes) was added 0.44 g. of sensitizer D.  The mixture was stirred
until solution was complete.  After filtration to remove any
particulate matter, this solution was coated using spin-coating
techniques.

## Example 7

### Preparation of Cyclized Rubber

In an inert atmosphere dried cis-1,4-polyisoprene (10 g.) was dissolved in 200 g. of dried ethyl benzene. To this solution 0.5 g. of fluroboric acid was added slowly with vigorous stirring. The reaction mixture was heated and the cyclization was monitored by removing small samples for measurement of residual unsaturation. When the desired degree of cyclization (unsaturation) was attained, the reaction mixture was cooled to room temperature and 10 g. of calcium carbonate 33 percent aqueous slurry was added. After filtration, the cyclized rubber solution was added to an excess of methanol to precipitate the rubber. The rubber was filtered, and washed well with methanol.

### Fractionation of Cyclized Rubber

The cyclized rubber is dissolved in benzene to form a 3 percent solution. With vigorous stirring the non-solvent methanol is added slowly until the precipitated rubber phase has the desired polydispersity and Aw as measured by GPC. At that point the precipitated rubber is separated and the non-solvent is removed by vacuum distillation.

### Preparation of Photoresists

To 100 g. of an 11 percent cyclized rubber solution ( in mixed xylenes) was added 0.44 g. of sensitizer D. The mixture was stirred until solution was complete. After filtration to remove any particulate matter, this solution was coated using spin-coating techniques.

As heretofore stated, the film-forming negative photoresists of this invention are characterized by both high photospeed and high window-opening index. The negative resists are capable of packing about twice as many lines in a given space as prior art resists and are a significant improvement when compared to currently commercially available negative photoresists.

As heretofore stated, the polymer component of the resists are characterized by a narrow range of polydispersivity, said range being greater than 1.865, a specific range of weight average molecular weights and unsaturations.

As can be seen from the foregoing, the film-forming negative resists of this invention are obtained by methods which are readily usable in commercial production. All of the methods usable to prepare the film-forming negative resists of this invention are such that a commercially competitive product is obtainable.

While the invention has been described as embodied in a cyclized rubber film forming negative photoresist composition, it is not intended to be limited to the details shown, since various modifications and changes may be made without departing in any way from the spirit of the present invention.

Without further analysis, the foregoing will so fully reveal the gist of the present invention that others can by applying current knowledge readily adapt it for various applications without omitting features that, from the standpoint of prior art, fairly constitute essential characteristics of the generic or specific aspect of this invention and, therefore, such adaptations should and are intended to be comprehended within the meaning and range of equivalence of the following claims.

Claims

1.      A film-forming negative photoresist composition comprising a cyclized rubber polymer and an aryl bis-azide sensitizing compound which decomposes upon exposure to image-modulate light of selected wavelengths to yield a structure capable of inducing cross-linking of the polymer in the exposed areas of the composition, the polymer having a polydispersivity of greater than 1.865 and an unsaturation range of between about 6.0 to about 8.2 millimoles-unsaturation/gram the photoresist composition having a constitution such that it has a window-opening index below a line B of FlG. 1 and a photospeed below a line A of FIG. 1.

2.      The composition of Claim 1, wherein the bis-azide sensitizing compound is 2,6-Bis(4'-azidobenzylidiene)-4-methylcyclohexane.

3.      The composition of Claim 1 or Claim 2 wherein the bis-azide sensitizing compound comprises from about one to five weight percent based on the cyclized rubber polymer.

4.      A method preparing a cyclized rubber polymer which is usable to form the film forming negative resist composition of Claim 1, said method comprising the step of:

     A)      dissolving a rubber polymer in an organic solvent to form a solution;

     B)      adding a cyclization agent to the solution; and

     C)      monitoring the solution of step B for a desired residual unsaturation of about 6.0 to about 8.2 millimoles unsaturation/gram and to ascertain if it has the characteristics of the cyclized rubber polymer of Claim 1 and to further ascertain if it will form the film forming negative resist composition of Claim 1 when mixed with an aryl bis-azide sensitizing compound of the type described in Claim 1.

5.      The method of Claim 4, wherein the cyclizing agent is acidic and wherein the solution is first heated, then cooled and then has a quenching agent added to it.

6.      The method of Claim 4 or Claim 5, wherein in step A a rubber polymer selected from dried cis-1,4-polyisoprene, dried 1,4-polybutadiene, dried natural rubber (hevea or Balata), and dried trans-1,4-polyisoprene is dissolved in an organic solvent selected from anhydrous benzene, anhydrous toluene, anhydrous ethyl benzene, or anhydrous meta/para xylene mixture; and in step B the cyclizing agent is selected from paratoluene sulfonic acid monohydrate, sulfuric acid, trichloroacetic acid, titanium tetrachloride or fluoroboric acid.

7.      A method according to any of Claims 4 to 6 wherein in step C the solution of step B is monitored for a residual unsaturation of about 6.5 to about 8.2 millimoles unsaturation/gram.

8.      A method according to any of Claims 4 to 7 wherein the resulting cyclised rubber is fractionated to separate a fraction having the desired polydispersivity, and Aw.

9.      A method of preparing a cyclized rubber polymer which is usable to form the film-forming negative resist composition of Claim 1, said method comprising the steps of:

      A)   providing a starting cyclized rubber polymer having a weight average molecular weight of between about 3,000 to about 7,000, a polydispersivity of between about 2.3 to about 3.5 and an unsturation value of between about 6.0 to about 8.2 millimoles unsaturation/gram;

      B)   dissolving said starting cyclized rubber polymer in an organic liquid to form a solution;

      C)   adding to the cyclized rubber solution another organic liquid in which the starting cyclized rubber polymer is insoluble, for pregressive solvent phase-separated frctionation of the cyclized rubber polymer, each progressive phase-separated fraction having progressively varying weight average molecular weights and progressively varying polydispersivities, each progressive phase-separated fraction preferably having the same unsaturation value of between about 6.0 to about 8.2 millimoles unsaturation/gram; and

D)    monitoring the combined phase-separated fractions to ascertain if a combined phase-separated fraction has the characteristics of the cyclized rubber polymer of Claim 1 and to ascertain if the combined phase-separated fraction, when mixed with an aryl bis-azide sensitizing compound of the type described in Claim 1, yields the film-forming negative photoresist compostion of Claim 1.

10.    A light-sensitive photographic material comprising a substrate and a coating thereon of a composition comprising an aryl bis-azide sensitizing compound and a cyclized rubber polymer, said material being adapted to produce a photographic image upon exposure to light, said cyclized rubber polymer having a polydispersivity of greater than 1.865 and an unsaturation range of between about 6.0 to about 8.2 millimoles unsaturation/gram, said coating having a constitution such that it has a window-opening index below a line B of FIG. 1 and a photospeed below a line A of FIG. 1.

+40 TO -60 RELATIVE PHOTOSPEED TO KODAK 747
60 TO >130 WINDOW OPENING INDEX
UPPER SPEED THRESHOLD
UPPER WINDOW OPENING INDEX THRESHOLD

Fig. 1

## DOCUMENTS CONSIDERED TO BE RELEVANT

| Category | Citation of document with indication, where appropriate, of relevant passages | Relevant to claim |
|---|---|---|
| A,D | US - A - 3 669 662 (R.K.AGNIHOTRI)<br>* Claims *<br>-- | 1-3 |
| A,D | US - A - 3 669 669 (D.L. KLEIN)<br>* Claim 1; column 5, lines 1-27 *<br>-- | 1-3 |
| A | GB - A - 658 520 (RUBBER-STITCHING)<br>* Page 1, lines 34-61; claims *<br>---- | 1,4,6 |

**CLASSIFICATION OF THE APPLICATION (Int. Cl. 3)**

G 03 F 7/08
G 03 F 7/26
G 03 C 1/71
C 08 C 19/10
C 08 L 15/00

**TECHNICAL FIELDS SEARCHED (Int.Cl. 3)**

G 03 F
G 03 C
C 08 C
C 08 L

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| X | The present search report has been drawn up for all claims |
|---|---|

| Place of search | Date of completion of the search | Examiner |
|---|---|---|
| VIENNA | 28-06-1982 | SALTEN |

EPO Form 1503.1 06.78